# EUROPÄISCHE PATENTSCHRIFT

(11) **EP 1 516 427 B1**
(45) Veröffentlichungstag und Bekanntmachung des Hinweises auf die Patenterteilung: **07.01.2009**
(21) Anmeldenummer: 03761432.8
(22) Anmeldetag: 25.06.2003
(51) Int. Cl.: H03C 3/09

(54) **SCHALTUNGSANORDNUNG MIT PHASENREGELKREIS UND SENDEEMPFÄNGER MIT DER SCHALTUNGSANORDNUNG**
CIRCUIT ARRANGEMENT PROVIDED WITH A PHASE-LOCKED LOOP AND TRANSMITTER-RECEIVER WITH SAID CIRCUIT ARRANGEMENT
ENSEMBLE CIRCUIT COMPORTANT UNE BOUCLE A PHASE ASSERVIE ET EMETTEUR-RECEPTEUR EQUIPE DUDIT ENSEMBLE CIRCUIT

(30) Priorität: 27.06.2002 DE 10228759; 18.09.2002 DE 10243382
(43) Veröffentlichungstag der Anmeldung: 23.03.2005
(73) Patentinhaber: Infineon Technologies AG, 81669 München (DE)
(72) Erfinder: CONVENT, Thomas, 47661 Issum (DE); HAMMES, Markus, 46539 Dinslaken (DE); HANKE, André, 40468 Düsseldorf (DE); LI PUMA, Giuseppe, 44791 Bochum (DE); MEVISSEN, Walter, 40227 Düsseldorf (DE)
(74) Vertreter: Epping - Hermann - Fischer
(86) Internationale Anmeldenummer: PCT/DE2003/002118
(87) Internationale Veröffentlichungsnummer: WO 2004/004267

(56) Entgegenhaltungen:
- EP-A- 0 961 412
- WO-A-01/93415
- US-A- 5 952 895

## Beschreibung

Die vorliegende Erfindung betrifft eine Schaltungsanordnung mit Phasenregelkreis sowie einen Sendeempfänger mit der Schaltungsanordnung.

Es sind mehrere Architekturen für Mobilfunksender bekannt, die mit geringem Aufwand realisiert werden können. Insbesondere bei solchen Funksendern, die mit Zeitschlitzen, sogenannten Bursts, arbeiten, bietet sich die sogenannte Open-Loop-Modulation an. Dabei schwingt ein Phasenregelkreis zunächst auf die gewünschte Sendefrequenz ein. Vor der eigentlichen Nutzdatenübertragung wird die Regelschleife geöffnet und der Träger bei geöffneter Regelschleife mit dem Modulationssignal moduliert. Dieses Prinzip hat jedoch den Nachteil, daß sich aufgrund von Drift-Effekten die Trägerfrequenz im offenen Betrieb ändern kann, so daß Spezifikationen nicht mehr eingehalten werden können. Dies kann mit verhältnismäßig aufwendigen Stabilisierungseinrichtungen verhindert werden.

Es ist weiterhin bekannt, als Alternative zur Realisierung eines Funksenderkonzeptes für moderne Mobilfunksysteme die sogenannte Zwei-Punkt-Modulation einzusetzen. Bei der ZweiPunkt-Modulation wird in eine Phasenregelschleife das Modulationssignal an zwei Einkoppelpunkten eingespeist. Von diesen beiden Einkoppelpunkten der Regelschleife hat einer Hochpaßeigenschaften und einer Tiefpaßeigenschaften. Während der Einspeisung des Modulationssignals bleibt dabei die Phasenregelschleife geschlossen. Demnach sind die bei der Open-Loop-Modulation auftretenden Drifteffekte des Trägers vermieden. Mit Vorteil können bei der Zwei-Punkt-Modulation Modulationssignale übertragen werden, deren Bandbreite größer ist als die eigentliche Modulationsbandbreite der Phasenregelschleife. Somit kann die eigentliche Bandbreite der Regelschleife verhältnismäßig klein ausgelegt werden, was wiederum die Rauscheigenschaften der Anordnung deutlich verbessert. Dabei ist ein Zwei-Punkt-Modulator mit verhältnismäßig geringem Aufwand herstellbar.

Ein derartiger Zwei-Punkt-Modulator ist in der Druckschrift DE 199 29 167 A1 angegeben. Dort ist eine Phasenregelschleife, PLL gezeigt, in die ein Modulationssignal sowohl an einem Hochpaß-Punkt am Eingang des Oszillators, als auch an einem Tiefpaß-Punkt im Rückführungszweig der PLL eingespeist wird.

Prinzipiell sind mehrere Möglichkeiten denkbar, die Einkoppelpunkte für das Modulationssignal in die Regelschleife auszuwählen. Beispielsweise kann das Modulationssignal in digitaler Form einem Frequenzteiler im Rückkopplungspfad der Phasenregelschleife zugeführt werden, wobei dieser Frequenzteiler dann normalerweise als Fractional-N-Teiler arbeitet. Zugleich wird das gleiche Modulationssignal, jedoch in analog codierter Form, an einem Eingang des Oszillators der Phasenregelschleife eingespeist, der normalerweise als spannungsgesteuerter Oszillator ausgeführt ist.

Bei einer derartigen Zwei-Punkt-Modulation mit einer Kombination aus digitalem und analogem Modulieren ist darauf zu achten, daß das analoge und das digitale Modulationssignal gleichphasig sind und daß eine gute Übereinstimmung der Amplituden dieser beiden Signale vorliegt. Aufgrund von bei Massenfertigung unvermeidlichen Herstellungstoleranzen der Bauteilkomponenten, die für die analoge Modulation von Bedeutung sind und beispielsweise die Modulationssteilheit, die Modulationsspannungserzeugung usw. beeinflussen, ist es erforderlich, nach der Fertigung eines derartigen Funksenders einen Amplitudenabgleich zwischen analoger und digitaler Modulation vorzunehmen. Wenn auch Temperatureinflüsse auf die Parameter der verwendeten Bauteile berücksichtigt werden sollen, ist es wünschenswert, einen derartigen Abgleich nicht nur einmalig bei der Fertigung, sondern vor jedem Sendevorgang durchzuführen.

Eine Möglichkeit, diesen Abgleich durchzuführen, besteht darin, ein gesendetes, moduliertes Signal mit einem zusätzlichen Meßempfänger zu empfangen, zu demodulieren, den Modulationshub zu messen und mit den derart gewonnenen Daten einen Abgleich vorzunehmen. Die Abgleichinformationen müssen dann allerdings im Gerät selbst in einem Speicher abgelegt werden. Außerdem können auf diese Weise lediglich fertigungsbedingte, nicht jedoch temperaturbedingte oder alterungsbedingte Drifteffekte berücksichtigt werden.

Eine weitere Möglichkeit könnte darin bestehen, den Empfangsteil eines Sendeempfängers dazu zu benutzen, den Sendeteil abzugleichen. Damit wäre jedoch der Nachteil verbunden, daß man eine zusätzliche Phasenregelschleife vorsehen müßte, die bei einem Heterodyn-Empfänger auf eine Frequenz eingestellt werden müßte, die der Differenzfrequenz von Sendefrequenz und Zwischenfrequenz entspricht.

Das Dokument US-A-5,952,895 zeigt einen Phasenregelkreis mit einer Referenzquelle, einem Phasendetektor, einem Oszillator und einem Modulator.

Der vorliegenden Erfindung liegt die Aufgabe zugrunde, eine Schaltungsanordnung mit Phasenregelkreis sowie einen Sendeempfänger mit der Schaltungsanordnung anzugeben, welche einen Modulatorabgleich mit geringem schaltungstechnischen Aufwand ermöglichen.

Erfindungsgemäß wird die Aufgabe gelöst durch eine Schaltungsanordnung mit Phasenregelkreis, aufweisend
- eine Referenzquelle zur Bereitstellung eines Signals mit einer Referenzfrequenz,
- einen Phasendetektor mit einem ersten Eingang, der an die Referenzquelle angeschlossen ist, mit einem zweiten Eingang und mit einem Ausgang,
- einen Oszillator, mit einem Steuereingang, der mit dem Ausgang des Phasendetektors gekoppelt ist, und mit einem Ausgang, der mit dem zweiten Eingang des Phasendetektors gekoppelt ist,
- einen Modulator mit einem Ausgang, an dem ein Modulationssignal bereitsteht und der mit dem Steuereingang des Oszillators gekoppelt ist, und
- einen Abgleichpfad zum Abgleich des Modulators, umfassend einen Frequenzmischer mit einem ersten Eingang, der mit dem Ausgang des Oszillators gekoppelt ist, mit einem zweiten Eingang, der mit der Referenzquelle gekoppelt ist und mit einem Ausgang, der über einen Demodulator mit einem Steuereingang des Modulators gekoppelt ist.

Gemäß vorliegendem Prinzip wird das Ausgangssignal des Oszillators im Phasenregelkreis oder ein davon abgeleitetes Signal mit dem von der Referenzquelle bereitgestellten Referenzsignal der Phasenregelschleife oder einem davon abgeleiteten Signal gemischt. Das Ausgangssignal dieses Mischvorgangs, also das Ausgangssignal des Frequenzmischers im Abgleichpfad, wird anschließend demoduliert und zum Abgleich einem Steuer-eingang des Modulators zugeführt. Somit kann ein Amplitudenabgleich mit geringem Aufwand durchgeführt werden.

Bei dem vorliegenden Modulator können gemäß dem beschriebenen Prinzip nicht nur fertigungsbedingte Toleranzen, sondern auch temperaturbedingte Drifteffekte sowie Alterungseffekte kompensiert werden.

Besonders vorteilhaft kommt das vorliegende Prinzip bei Weiterbildung des Phasenregelkreises zu einem Zwei-Punkt-Modulator zur Geltung.

Hierbei ist im Rückkopplungspfad der Phasenregelschleife, also zwischen dem Oszillatorausgang und dem zweiten Eingang des Phasenvergleichers, ein Frequenzteiler vorgesehen. Dieser arbeitet bevorzugt als Fractional-N-Teiler und wird von dem Modulationssignal angesteuert. Die Ansteuerung des Frequenzteilers mit dem Modulationssignal erfolgt bevorzugt digital. Ein derartiger, zur digitalen Modulation ausgebildeter Frequenzteiler kann vom Modulationssignal bevorzugt mittels eines Sigma-Delta-Wandlers angesteuert werden.

Dabei sind der Analogmodulator, der den Oszillator ansteuert, und der Frequenzteiler bevorzugt an eine gemeinsame Modulations-Signalquelle angeschlossen.

Gemäß einer bevorzugten Weiterbildung des vorliegenden Prinzips ist ein Frequenzvervielfacher vorgesehen, mit einem Eingang, der mit der Referenzquelle verbunden ist, und mit einem Ausgang, der an den zweiten Eingang des Frequenzmischers im Abgleichpfad angeschlossen ist.

Mit dem Frequenzvervielfacher ist es mit geringem Aufwand möglich, das Ausgangssignal des Phasenregelkreises auf eine Frequenzebene herunterzumischen, die der Demodulation mit dem Demodulator zugänglich ist. Das Heruntermischen und Demodulieren der Ausgangsfrequenz oder davon abgeleiteten Signals erfolgt dabei mit Vorteil mit sehr geringem Phasenrauschen. Außerdem ergibt sich eine gute Integrierbarkeit des Abgleichpfades. Das von der Referenzquelle in Kombination mit dem Frequenzvervielfacher bereitgestellte Signal arbeitet somit als Lokaloszillatorsignal, mit dem das Ausgangssignal des Oszillators oder ein davon abgeleitetes Signal im Abgleichpfad auf eine Zwischenfrequenzebene heruntergemischt wird.

Die Frequenzvervielfachung erfolgt dabei bevorzugt mit einem ganzzahligen Wert, das heißt, daß das am Ausgang des Frequenzvervielfachers bereitgestellte Signal eine Frequenz hat, die gleich einem ganzzahligen Vielfachen der von der Referenz-Quelle bereitgestellten Referenzfrequenz ist.

Der erste Eingang des Frequenzmischers kann alternativ zur direkten Verbindung mit dem Ausgang des Oszillators auch mit dem Ausgang einer dem Oszillator nachgeschalteten Frequenzaufbereitungsstufe verbunden sein.

Besonders bei integrierten Modulfunksendern ist es vorteilhaft, das Ausgangssignal des Oszillators so aufzubereiten, daß eine frequenzmäßige Entkopplung des Ausgangssignals der Gesamtanordnung von der Frequenz, auf der Oszillator schwingt, erzielt ist.

Der mit dem Steuereingang des Oszillators gekoppelte Modulator ist bevorzugt zur analogen Modulation des Steuersignals des Oszillators ausgebildet.

Zur Kopplung des Demodulators mit dem den Oszillator an seinem Steuereingang ansteuernden Modulator ist bevorzugt eine Auswerteeinheit vorgesehen. Die Auswerteeinheit ist bevorzugt zur Erfassung des analogen Modulationshubes oder eines davon abhängigen Signals ausgelegt. In Abhängigkeit von der aktuellen Amplitude der Modulation wird von der Auswerteeinheit der Modulator angesteuert.

Gemäß einer bevorzugten Weiterbildung der vorliegenden Erfindung ist die Phasenregelschleife mit einem spannungsgesteuerten Oszillator (VCO) ausgebildet, wobei zur Aufbereitung des am Ausgang des Phasendetektors ableitbaren Signals eine Ladungspumpenschaltung mit nachgeschaltetem Schleifenfilter zwischen Phasendetektor und Steuereingang des VCO geschaltet sind. Der Ausgang des Schleifenfilters ist mit dem Steuereingang des VCO bevorzugt über einen Summierknoten verbunden, mit einem weiteren Eingang am Summierknoten, der mit dem Modulator verbunden ist.

Alternativ kann auch ein VCO mit zwei Eingängen, die gegebenenfalls verschiedene Verstärkungen haben können, vorgesehen sein.

Bezüglich des Sendeempfängers wird die Aufgabe gelöst durch einen Sendeempfänger mit einer Schaltungsanordnung mit Phasenregelkreis wie vorstehend beschrieben. Der Sendeempfänger umfaßt einen Sendezweig und einen Empfangszweig. Der eigentliche Phasenregelkreis ist in dem Sendezweig, als Direktmodulator arbeitend, angeordnet. Der Abgleichpfad der Schaltungsanordnung umfaßt den Demodulator, welcher ebenso wie der Frequenzmischer in dem Empfangszweig angeordnet ist. Da in einem Sendeempfänger im Empfangszweig ohnehin üblicherweise ein Demodulator und ein Frequenzmischer vorhanden sind, die ausgelegt sind zum Heruntermischen und Demodulieren eines empfangenen Nutzsignals, können diese mit Vorteil von der erfindungsgemäß vorgesehenen Abgleichanordnung mitbenutzt werden.

Bevorzugt sind entsprechende Umschalter oder Bandpaßfilter, sogenannte Duplexer, vorgesehen, mit denen eine Umschaltung zwischen einem Abgleichbetrieb und einem Nutzbetrieb bezüglich des Empfangszweiges möglich wird.

Weitere Einzelheiten und vorteilhafte Ausgestaltungen der Erfindung sind Gegenstand der Unteransprüche.

Die Erfindung wird nachfolgend an einem Ausführungsbeispiel anhand der Figur näher erläutert. Es zeigen:
- Figur 1: ein erstes Ausführungsbeispiel des vorgeschlagenen Prinzips anhand eines Blockschaltbildes,
- Figur 2: ein zweites Ausführungsbeispiel des vorgeschlagenen Prinzips anhand eines Blockschaltbildes und
- Figur 3: ein Ausführungsbeispiel der Trägerfrequenzerzeugungsschaltung von Figur 2.

Gleiche Bezugszeichen bezeichnen nachstehend gleiche oder gleich wirkende Teile.

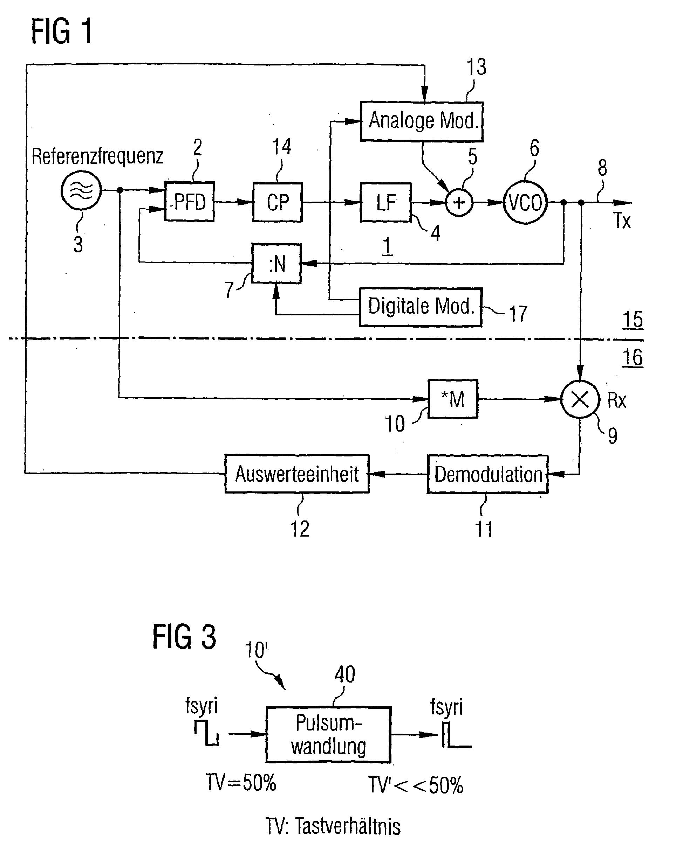

Figur 1 zeigt eine Schaltungsanordnung mit einem Phasenregelkreis 1. Der Phasenregelkreis 1 umfaßt einen Phasendetektor 2, mit einem ersten Eingang, einem zweiten Eingang und mit einem Ausgang. Mit dem ersten Eingang des Phasendetektors 2 ist eine Bezugsfrequenzquelle 3 verbunden. An den Ausgang des Phasendetektors 2 ist eine Ladungspumpenschaltung 14 angeschlossen, der ein Schleifenfilter 4 nachgeschaltet ist. An den Ausgang des Schleifenfilters 4 ist ein Summierglied 5 mit seinem ersten Eingang angeschlossen, dessen Ausgang mit dem Abstimmeingang eines spannungsgesteuerten Oszillators 6 verbunden ist. In einem Rückkopplungspfad, der einen Frequenzteiler 7 umfaßt, ist der Ausgang des Oszillators 6 mit dem zweiten Eingang des Phasendetektors 2 verbunden. Der Frequenzteiler 7 führt eine bevorzugt ganzzahlige Division durch N der Grundfrequenz durch. Hierfür ist der Ausgang des Oszillators 6, der auch den Ausgang 8 der gesamten Schaltungsanordnung bildet, mit einem Eingang des Frequenzteilers 7 verbunden, dessen Ausgang mit dem zweiten Eingang des Phasendetektors 2 verbunden ist. Der Frequenzteiler 7 weist einen digitalen Steuereingang auf, an den ein digitales Modulationssignal zuführbar ist. Dieser Steuereingang ist mit einer Modulations-Signalquelle 17 verbunden, die ein digital codiertes Modulationssignal liefert. Das Summierglied 5, dessen erster Eingang mit dem Ausgang des Schleifenfilters 4 verbunden ist, weist einen zweiten Eingang auf, der an einen Analogmodulator 13 angeschlossen ist und an dem ein analog codiertes Modulationssignal zugeführt wird. Das Modulationssiganl wird dem Analogmodulator von dem mit ihm verbundenen Modulations-Signalgenerator 17 zugeführt.

Da somit an zwei Einkoppelpunkten des als Modulator ausgebildeten Phasenregelkreises 1 das Modulationssignal in den Phasenregelkreis eingespeist wird, nämlich einem Hochpaß- und einem Tiefpaß-Einkoppelpunkt, arbeitet die vorliegende Schaltungsanordnung als Zwei-Punkt-Modulator.

Zur Bereitstellung eines Abgleichs für die analoge Modulation ist ein Abwärts-Frequenzmischer 9 vorgesehen, mit einem ersten Eingang, der an den Ausgang des Oszillators 6 angeschlossen ist, und mit einem zweiten Eingang, der an den Ausgang eines Frequenzvervielfachers 10 angeschlossen ist. Der Frequenzvervielfacher bewirkt eine bevorzugt ganzzahlige Multiplikation der Signalfrequenz mit dem Faktor M. Der Eingang des Frequenzvervielfachers 10 ist mit dem Ausgang der ohnehin vorhandenen Referenzfrequenzquelle 3 der PLL 1 verbunden. Der Ausgang des Abwärts-Frequenzmischers 9 ist mit dem Eingang eines Demodulators 11 verbunden, dessen Ausgang an den Eingang einer Auswerteeinheit 12 angeschlossen ist. Der Ausgang der Auswerteeinheit 12 ist mit einem Abgleicheingang des Analogmodulators 13 verbunden, der mit dem Summierknoten 5 verschaltet ist.

Der Phasendetektor 2 vergleicht die Referenzfrequenz mit der heruntergeteilten Ausgangsfrequenz des Oszillators und steuert in Abhängigkeit von dem Phasenunterschied zwischen beiden Signalen die Ladungspumpe 14 an. Diese gibt in Abhängigkeit von dem Phasenunterschied eine Ladungsmenge ab, die mit dem Schleifenfilter 4 in eine entsprechende Steuerspannung für den Oszillator 6 konvertiert wird. Gleichzeitig dient das Schleifenfilter 4 zur Stabilisierung der Regelschleife 1. Mit dem Verknüpfungsglied 5 wird der Steuerspannung für den Oszillator 6 ein analoges Modulationssignal überlagert, so daß am Ausgang des Oszillators 6 ein Trägersignal bereitsteht, welches moduliert ist. Dieses wird mit dem Frequenzteiler 7 im Rückkopplungspfad entsprechend frequenzmäßig heruntergeteilt. Zur Erhöhung der Modulationsbandbreite wird das dem Verknüpfungsglied 5 in analoger Form zugeführte Modulationssignal zugleich in digital codierter Form dem Frequenzteiler 7 im Rückkopplungspfad zugeführt. Somit steht eine Modulationsbandbreite zur Verfügung, die größer ist als die Bandbreite der Regelschleife 1. Um einen Amplitudenabgleich zwischen analoger und digitaler Modulation vornehmen zu können, ist der Frequenzmischer 9 vorgesehen, der unter Zuhilfenahme der vervielfachten Referenzfrequenz der PLL 1 das Ausgangssignal des Oszillators 6 auf eine Zwischenfrequenzebene heruntermischt. Dieses heruntergemischte Signal wird im Demodulator 11 demoduliert. In der Auswerteeinheit 12 wird das demodulierte Modulationssignal ausgewertet. Die Auswerteeinheit 12 erfaßt den aktuellen analogen Modulationshub, ermittelt eine Abweichung desselben von einem Soll-Wert und steuert entsprechend den Analogmodulator 13 an, derart, daß zwischen analoger und digitaler Modulation ein Amplitudenabgleich stattfindet. Dieser Amplitudenabgleich kompensiert sowohl fertigungsbedingte Toleranzen, als auch mit Vorteil Temperaturdrifts und Alterungseffekte.

Aufgrund der Vervielfachung der Referenzfrequenz der PLL 1 ist mit Vorteil keine zusätzliche Phasenregelschleife für den Abgleich gemäß vorliegendem Prinzip erforderlich. Somit ergeben sich gute Integrationsmöglichkeiten des vorliegenden Prinzips. Außerdem ist eine Frequenzvervielfachung mit deutlichen geringerem Phasenrauschen möglich als die Erzeugung einer Oszillatorfrequenz mit einer weiteren Phasenregelschleife. Dies ist insbesondere deshalb vorteilhaft, da das Phasenrauschen im Mischer 9 ebenfalls auf die Zwischenfrequenz heruntergemischt wird. Das Phasenrauschen wirkt sich durch die Demodulation 11 auch auf das demodulierte Signal aus und würde somit den Abgleich verfälschen oder unmöglich machen.

Die vorliegende Erfindung ermöglicht den Aufbau eines Mobilfunksenders mit besonders geringem Aufwand, geringer Anzahl der erforderlichen Bauteile, geringem Stromverbrauch und geringer Chipfläche. Der Sender zeigt dabei gute Rauscheigenschaften.

Anstelle der gezeigten Anwendung des erfindungsgemäßen Prinzips auf eine Zwei-Punkt-Modulation ist das beschriebene Prinzip auch in Systemen mit ausschließlich analoger Modulation anwendbar.

Der Demodulator 11 ist im Empfangszweig 16 eines Transceivers angeordnet, in dessen Sendezweig 15 der Phasenregelkreis 1, der als Zwei-Punkt-Modulator ausgebildet ist, angeordnet ist Zusätzliche Schalter, Filter etc. zum Umschalten zwischen Nutzsignalempfang und Abgleichbetriebsart im Empfangszweig 11 sind gemäß Figur 1 nicht eingezeichnet, liegen jedoch im Rahmen der Erfindung.

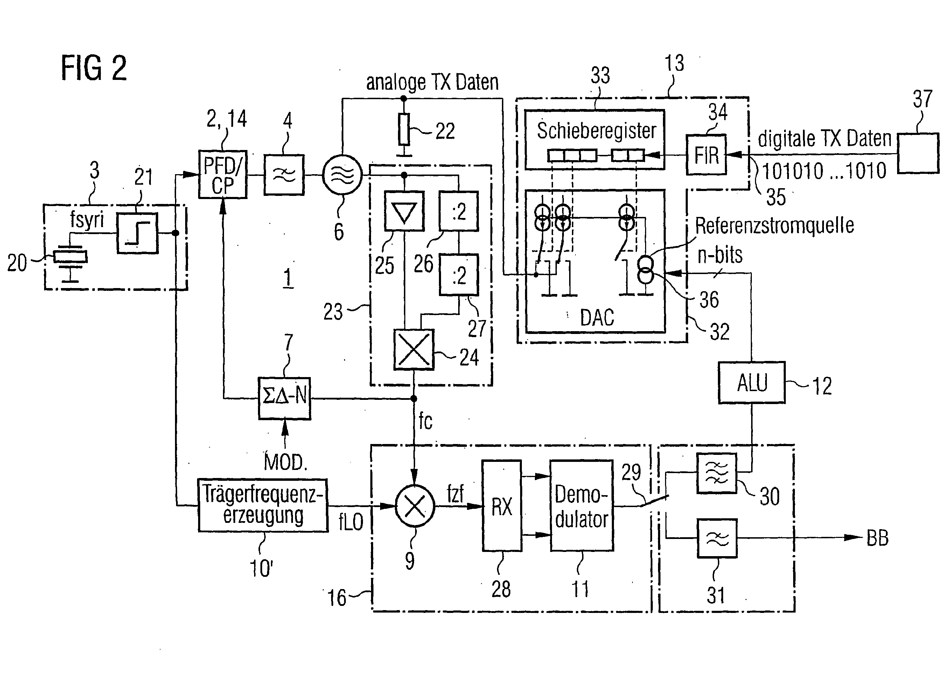

Figur 2 zeigt eine Weiterbildung der Prinzipdarstellung einer Schaltungsanordnung mit Phasenregelkreis, welche ebenfalls auf dem Prinzip der Zweipunkt-Modulation beruht. Insoweit die Merkmale der Figur 2, die einzelnen Schaltungsteile, deren Verschaltung miteinander sowie das vorteilhafte Zusammenwirken derselben mit der Figur 1 übereinstimmen, wird diese Beschreibung nicht noch einmal wiederholt.

Der zur Zweipunkt-Modulation ausgelegte Phasenregelkreis 1 von Figur 2 umfaßt einen Referenzgenerator 3, der einen Schwingquarz 20 mit nachgeschaltetem Rechtecksignalgenerator 21 aufweist, welcher das sinusförmige Oszillatorsignal des Quarzes in ein periodisches Rechtecksignal umwandelt. Der Ausgang des Referenzfrequenzgenerators 3 ist an einen Eingang des Phasendetektors 2 angeschlossen, der in Figur 2 als Einheit mit der Ladungspumpe 14 gezeichnet ist. An den Ausgang dieses Phasendetektors mit nachgeschalteter Ladungspumpe 2, 14 ist über Tiefpaßfilter 4 der spannungsgesteuerte Oszillator 6 angeschlossen. Der Summierknoten 5 von Figur 1 ist bei der Schaltung von Figur 2 in den Oszillator 6 hinein verlegt, der vorliegend zwei Abstimmeingänge hat. Die Abstimmeingänge können dabei mit gleicher oder mit unterschiedlicher Verstärkung ausgeführt sein. Der weitere Eingang des Oszillators 6 ist zur Zuführung analoger Sendedaten, das heißt analoger Modulationsdaten ausgelegt und über einen Widerstand 22 gegen Bezugspotential geschaltet. Der Ausgang des Oszillators 6 ist über eine Frequenzaufbereitungsschaltung 23 an den Eingangeines ΣΔ-Fractional-N-Teilers angekoppelt, dessen Ausgang mit einem weiteren Eingang der Phasendetektoreinheit 2, 14 verbunden ist.

Ein Zweipunkt-Modulator ist dabei vorliegend mit zwei Modulationssignal-Einkoppelpunkten gebildet, von denen einer an einem Eingang des Oszillators 6 und ein weiterer an einem Steuereingang des ΣΔ-Fractional-N-Frequenzteilers vorgesehen ist.

Die Frequenzaufbereitungsschaltung 23 umfaßt einen Hochfrequenzmischer 24 mit einem ersten Eingang, der über einen ersten Signalpfad an den Ausgang des Oszillators 6 angeschlossen ist, und einen zweiten Eingang, der über einen zweiten Signalpfad an den Ausgang des Oszillators 6 angeschlossen ist. Der erste Signalpfad umfaßt einen Verstärker 25 zur Kopplung von Oszillator 6 und Mischer 24. Der zweite Signalpfad umfaßt eine Serienschaltung aus zwei Frequenzteilern 26, 27, die den Ausgang des Oszillators 6 mit dem zweiten Eingang des Mischers 24 verbinden und je eine Frequenzteilung durch zwei bewirken. Zum Abgleich des Regelkreises 1, insbesondere der analogen Modulation derselben, ist ein Rückkopplungspfad vom Ausgang der Aufbereitungsschaltung 23 zum Analog-Modulationseingang des Oszillators 6 gebildet, der unter anderem den Frequenzmischer 9, den Demodulator 11, die Auswerteeinheit 12 und den Analog-Modulator 13 umfaßt.

Der Frequenzmischer 9 ist mit seinem ersten Eingang an den Ausgang der Aufbereitungsschaltung 23, dort an den Ausgang des Mischers 24 angeschlossen. Der Lokaloszillatorsignaleingang des Mischers 9 ist mit dem Ausgang der Trägerfrequenzerzeugungsschaltung 10' verbunden, deren Eingang ebenso wie der Phasendetektor 2 an den Ausgang des Referenzgenerators 3 angeschlossen ist. Im Unterschied zur Schaltung von Figur 1 ist die Trägerfrequenzerzeugungsschaltung 10' jedoch nicht als Frequenzmultiplizierer ausgelegt, sondern als Pulsumwandlungsschaltung, die das Tastverhältnis von 50 % des Referenzfrequenzsignals in ein Signal mit deutlich geringerem Tastverhältnis TV konvertiert, also zu einem Tastverhältnis TV' << 50%. Der Ausgang des Frequenzmischers 9 ist an eine Empfangs signal aufbereitungs schaltung 28 angeschlossen, welche ein Filter mit nachgeschaltetem Limiter, also einem begren-zenden Verstärker, umfaßt. Der Ausgang dieses Empfangsblocks 28 ist mit dem Eingang eines Frequenzdemodulators 11 verbunden. Die Blöcke Frequenzmischer 9, Empfangsaufbereitung 28 und Demodulator 11 bilden gemeinsam einen Teil des Empfangssignalpfads 16 in einem Funkempfänger.

Am Ausgang des Demodulators 11 ist ein Schalter angeschlossen, der Bezugszeichen 29 trägt und den Demodulatorausgang entweder mit einem schmalbandigen Filter 30 oder mit einem Tiefpaßfilter 31 verbindet. Dem Tiefpaßfilter 31 schließt sich eine Basisband-Signalverarbeitungskette des Empfängers an. An den Ausgang des schmalbandigen Filters 30 hingegen ist eine Auswerteeinheit 12 angeschlossen, welche eine Steuerlogik und eine ALU, Arithmetic Logical Unit, umfaßt. Diese gibt ein digitales, paralleles Steuersignal zur Beeinflussung der Analogmodulation ab, wofür ihr Ausgang an den Eingang eines Digital/Analog-Wandlers 32 angeschlossen ist.

Der D/A-Wandler 32 ist zusammen mit einem Schieberegister 33 und einem FIR-Filter 34 in einer Analogmodulator-Einheit 13 angeordnet. Digitale Sendedaten, mit denen ein Trägersignal moduliert werden soll, sind an einem Eingang 35 des Filters 34 zuführbar. Hierfür ist ein Testdatengenerator 37 am Eingang des Filters 34 angeschlossen, der zur Erzeugung periodischer Bitmuster ausgelegt ist. Der Ausgang des FIR-Filters 34 steuert den seriellen Eingang eines Schieberegisters 33 an, welches der Seriell/Parallel-Wandlung dient. Am Parallelausgang des Schieberegisters 33 ist je eine schaltbare Stromquelle im D/A-Wandler 32 angekoppelt. Die Auswerteeinheit 12 ist mit dem Steuereingang einer Referenzstromquelle im D/A-Wandler 32 verbunden zur Steuerung des Referenzstroms für die Stromquellen desselben. Am Ausgang steht demnach ein Stromsignal zur Verfügung, welches sowohl von dem rückgekoppelten Kalibrierwert, als auch von den Sendedaten abhängt. Die Auswerteeinheit 12 bewirkt eine Kalibrierung des Stromwerts, der vom D/A-Wandler bereitgestellt wird und in Abhängigkeit von dem Referenzstromwert und den digitalen Sendedaten am Eingang 35 erzeugt wird.

Die Signalaufbereitungsschaltung 23 ermöglicht mit Vorteil eine Entkopplung der Schwingfrequenz des Oszillators 6 von der Trägerfrequenz, so daß unerwünschte Störsignalkopplungen vermieden werden.

Die Phasenregelschleife 1 umfaßt zwei Einkoppelpunkte, von denen einer Tiefpaßeigenschaften und einer Hochpaßeigenschaften hat. Der Digitalanteil des Modulationssignals wird am ΣΔ-Fractional-N-Teiler 7 zugeführt, der eine ΣΔ-Modulation bewirkt. Der Analoganteil des Modulationssignals hingegen wirkt gewichtet mit einer Hochpaßübertragungsfunktion auf das Ausgangssignal der Regelschleife und wird am VCO 6 eingespeist. Der digitale Modulationshub wird exakt auf den gewünschten Nominalwert eingestellt. Fertigungstoleranzen, Drifteffekte werden durch den beschriebenen Abgleich des analogen Modulationshubs abgeglichen. Zur Messung des Modulationshubs wird am Eingang 35 eine schnelle Folge von 1010-Pegelwechseln eingespeist, der Träger somit moduliert und der Modulationshub gemessen. Aufgrund der Hochpaßwirkung bezüglich der analogen Modulation kann bei derartigen, schnellen Wechseln bezüglich der Anteile der Modulation auf die Größe des analogen Modulationssignals geschlossen werden, ohne einen Anteil der Regelwirkung der Schleife oder der digitalen Modulation als Einfluß zu beinhalten.

Dieses Prinzip bringt den zusätzlichen Vorteil, daß die Regelschleife während der Messung des Modulationshubs die ganze Zeit geschlossen bleibt, also keinen Einflüssen bezüglich Drift et cetera unterliegt. Das Ausgangssignal wird ausschließlich durch den Anteil der Analog-Modulation bestimmt. Da die Frequenzumsetzung nach oben immer mit einer Erhöhung des Phasenrauschens verbunden ist, welches unvermeidlich ist und sich auch bei dem Mischvorgang in das Zwischenfrequenzsignal mit überträgt, wird dieses zusätzliche Rauschen mit berücksichtigt. Das Rauschen zeigt sich als Restfrequenzmodulationsanteil nach der Demodulation. Hierzu wird bevorzugt das Maximum und Minimum über eine entsprechend lange Anzahl der 101010-Auslenkungen des am Eingang 35 zugeführten Testsignals gemessen. Der sich ergebende Mittelwert entspricht dann der aktuellen Analogmodulation, welche entsprechend mit der Referenzstromquelle im D/A-Wandler 36 nachgeregelt wird.

Alternativ zur Mittelwertbildung nach Messung von Minimum und Maximum könnte auch der arithmetische Mittelwert über eine Vielzahl von Messungen des Modulationshubs bestimmt werden.

Selbstverständlich sind auch andere Möglichkeiten zur Bestimmung des tatsächlichen Modulationshubs denkbar, welche im Rahmen der Erfindung liegen.

Wichtig ist zu beachten, daß die Anzahl der berücksichtigten Meßwerte in Abhängigkeit des vorkommenden möglichen Frequenzanteils des Phasenrauschens geregelt wird, damit auftretende Frequenzkomponenten entsprechend herausgemittelt werden.

Eine zusätzliche Verbesserung der Unterdrückung unerwünschter Frequenzanteile ergibt sich durch Einfügen des schmalbandigen Filters 30, welches zum Kalibrierbetrieb, das heißt während das Testsignal am Eingang 35 eingespeist wird, in die Rückkopplungsschleife des Kalibrierpfads eingeschaltet wird. Hierdurch werden weitere Frequenzanteile des Rauschens nach der Demodulation herausgefiltert.

Die Trägerfrequenzerzeugung 10' kann beispielsweise mittels eines einfachen Frequenzvervielfachers, einer Phasenregelschleife oder einer Verzögerungsregelschleife erfolgen.

Es hat sich gezeigt, daß es anwendungsabhängig sinnvoll sein kann, eine Bitfolge 11001100... vom Testdatengenerator erzeugen zu lassen. Selbstverständlich können im Rahmen der Erfindung auch beliebig andere, periodische Bitmusterfolgen zur Kalibrierung der Modulation in der Regelschleife gemäß dem vorgestellten Prinzip verwendet werden. Bei Verwendung des schmalbandigen Filters 30 ist dessen Durchlaß-Charakteristik entsprechend anzupassen.

Figur 3 zeigt eine weitere Möglichkeit der Ausführung der Trägerfrequenzerzeugungsschaltung 10' zur Erzeugung einer Lokaloszillatorfrequenz für den Frequenzmischer 9. Dieser beruht auf dem Prinzip einer Pulsumwandlung mit einem Pulsumwandlungsblock 40, dessen Eingang mit dem Ausgang des Frequenzgenerators 3 verbunden ist. An diesem Ausgang wird ein periodisches Rechtecksignal mit symmetrischem Tastverhältnis, das heißt einem Tastverhältnis TV = 50 % zugeführt.

Als Tastverhältnis wird dabei der Quotient aus logischem High-Pegel dividiert durch die Periodendauer verstanden.

Die Pulsformungsschaltung 40 bewirkt, daß an ihrem Ausgang ein Referenzsignal mit deutlich verringertem Tastverhältnis bereitsteht. Das Tastverhältnis TV' am Ausgang der Pulsumwandlungsschaltung 40 ist klein gegen 50 %. Hierdurch wird die gewünschte Frequenzvervielfachung erzielt, die bei der Ansteuerung des Mischers 9 den gewünschten, vorteilhaften Effekt wie bereits erläutert bewirkt.

### Bezugszeichenliste

- 1: Phasenregelkreis, PLL
- 2: Phasendetektor
- 3: Referenzgenerator
- 4: Schleifenfilter
- 5: Summierglied
- 6: VCO
- 7: Teiler
- 8: Ausgang
- 9: Frequenzmischer
- 10: Vervielfacher
- 11: Demodulator
- 12: Auswerteeinheit
- 13: Analogmodulator
- 14: Ladungspumpe
- 15: Sendezweig
- 16: Empfangszweig
- 17: Modulations-Signalquelle
- 20: Schwingquarz
- 21: Rechtecksignalwandler
- 22: Widerstand
- 23: Signalaufbereitungsschaltung
- 24: Mischer
- 25: Verstärker
- 26: Frequenzteiler
- 27: Frequenzteiler
- 28: Empfangssignalverarbeitung
- 29: Schalter
- 30: Schmalbandfilter
- 31: Tiefpaßfilter
- 32: D/A-Wandler
- 33: Schieberegister
- 34: FIR-Filter
- 35: Modulationseingang
- 36: Referenzstromquelle
- 40: Pulsumwandlungsschaltung

## Patentansprüche

1. Schaltungsanordnung mit Phasenregelkreis (1), aufweisend
- eine Referenzquelle (3) zur Bereitstellung eines Signals mit einer Referenzfrequenz,
- einen Phasendetektor (2) mit einem ersten Eingang, der an die Referenzquelle (3) angeschlossen ist, mit einem zweiten Eingang und mit einem Ausgang,
- einen Oszillator (6), mit einem Steuereingang, der mit dem Ausgang des Phasendetektors (2) gekoppelt ist, und mit einem Ausgang, der mit dem zweiten Eingang des Phasendetektors (2) gekoppelt ist, und
- einen Modulator (13) mit einem Ausgang, an dem ein Modulationssignal bereitsteht und der mit dem Steuereingang des Oszillators (6) gekoppelt ist,
**gekennzeichnet durch**
- einen Abgleichpfad zum Abgleich des Modulators (13), umfassend einen Frequenzmischer (9) mit einem ersten Eingang, der mit dem Ausgang des Oszillators (6) gekoppelt ist, mit einem zweiten Eingang, der mit der Referenzquelle (3) gekoppelt ist und mit einem Ausgang, der über einen Demodulator (11) mit einem Steuereingang des Modulators (13) gekoppelt ist.

2. Schaltungsanordnung nach Anspruch 1,
**dadurch gekennzeichnet, daß**
zur Kopplung des Ausgangs des Oszillators (6) mit dem zweiten Eingang des Phasendetektors (2) ein Frequenzteiler (7) vorgesehen ist zum Herunterteilen der Ausgangssignals des Oszillators (6).

3. Schaltungsanordnung nach 2,
**dadurch gekennzeichnet, daß**
der Frequenzteiler (7) einen Steuereingang ausgebildet zum Zuführen des Modulationssignals in digital codierter Form aufweist.

4. Schaltungsanordnung nach einem der Ansprüche 1 bis 3,
**dadurch gekennzeichnet, daß**
zur Kopplung des zweiten Eingangs des Frequenzmischers (9) mit der Referenzquelle (3) ein Frequenzvervielfacher (10) vorgesehen ist zur Vervielfachung der Referenzfrequenz.

5. Schaltungsanordnung nach einem der Ansprüche 1 bis 4,
**dadurch gekennzeichnet, daß**
zur Kopplung des Demodulators (11) mit dem Steuereingang des Modulators (13) eine Auswerteeinheit (12) vorgesehen ist.

6. Schaltungsanordnung nach Anspruch 5,
**dadurch gekennzeichnet, daß**
zwischen den Demodulator (11) und die Auswerteeinheit (12) ein Tiefpaßfilter geschaltet ist.

7. Schaltungsanordnung nach Anspruch 5,
**dadurch gekennzeichnet, daß**
der Demodulator (11) über eine Serienschaltung umfassend einen Schalter (29) und ein Bandpaßfilter (30) mit der Auswerteeinheit (12) gekoppelt ist, wobei der Durchlaßbereich des Bandpaßfilters (30) an die Frequenz des vom Testdatengenerator (37) erzeugten periodischen Signals angepaßt ist.

8. Schaltungsanordnung nach einem der Ansprüche 1 bis 7,
**dadurch gekennzeichnet, daß**
der Oszillator (6) als spannungsgesteuerter Oszillator ausgeführt ist und daß zwischen den Ausgang des Phasendetektors (2) und den Steuereingang des Oszillators (6) eine Serienschaltung aus einer Ladungspumpe (14), einem Schleifenfilter (4) und einem Summierknoten (5) geschaltet ist.

9. Schaltungsanordnung nach Anspruch 8,
**dadurch gekennzeichnet, daß**
der Ausgang des Modulators (13) mit einem Eingang des Summierknotens (5) verbunden ist.

10. Schaltungsanordnung nach einem der Ansprüche 1 bis 9,
**dadurch gekennzeichnet, daß**
ein Testdatengenerator (37) ausgelegt ist zur Erzeugung eines periodischen Signals und einen Ausgang hat, der an einen Eingang des Modulators (13) angeschlossen ist, und daß der Abgleichpfad zum Abgleich des Modulators (13) in Abhängigkeit von einem mit dem periodischen Signal erzeugten demodulierten Signal ausgelegt ist, wobei das demodulierte Signal am Ausgang des Demodulators (11) bereitgestellt wird.

11. Sendeempfänger mit einer Schaltungsanordnung nach einem der Ansprüche 1 bis 10, umfassend
- einen Sendezweig (15) zum Senden eines modulierten Signals, in dem die Schaltungsanordnung mit Phasenregelkreis (1), die als Direktmodulator arbeitet, angeordnet ist, und
- einen Empfangszweig (16) zum Empfangen eines modulierten Signals, in dem der Demodulator (11) angeordnet ist.

## Claims

1. Circuit arrangement with a phase locked loop (1), having
- a reference source (3) for providing a signal at a reference frequency,
- a phase detector (2) with a first input, which is connected to the reference source (3), with a second input and with an output,
- an oscillator (6), with a control input, which is coupled to the output of the phase detector (2), and with an output, which is coupled to the second input of the phase detector (2),
- a modulator (13) with an output, which provides a modulation signal and is coupled to the control input of the oscillator (6),
**characterized in that**
- a trimming path for trimming the modulator (13), comprising a frequency mixer (9) with a first input, which is coupled to the output of the oscillator (6), with a second input, which is coupled to the reference source (3), and with an output, which is coupled to a control input on the modulator (13) via a demodulator (11).

2. Circuit arrangement as claimed in Claim 1,
**characterized in that**
the output of the oscillator (6) is coupled to the second input of the phase detector (2) by providing a frequency divider (7) for the purpose of dividing down the output signals from the oscillator (6).

3. Circuit arrangement as claimed in Claim 2,
**characterized in that**
the frequency divider (7) has a control input designed to supply the modulation signal in digitally coded form.

4. Circuit arrangement as claimed in one of Claims 1 to 3,
**characterized in that**
the second input of the frequency mixer (9) is coupled to the reference source (3) by providing a frequency multiplier (10) for the purpose of multiplying the reference frequency.

5. Circuit arrangement as claimed in one of Claims 1 to 4,
**characterized in that**
the demodulator (11) is coupled to the control input of the modulator (13) by providing an evaluation unit (12).

6. Circuit arrangement as claimed in Claim 5,
**characterized in that**
a low-pass filter is connected between the demodulator (11) and the evaluation unit (12).

7. Circuit arrangement as claimed in Claim 5,
**characterized in that**
the demodulator (11) is coupled to the evaluation unit (12) via a series circuit comprising a switch (29) and a bandpass filter (30), the passband of the bandpass filter (30) matching the frequency of the periodic signal generated by the test data generator (37).

8. Circuit arrangement as claimed in one of Claims 1 to 7,
**characterized in that**
the oscillator (6) is in the form of a voltage-controlled oscillator, and **in that** a series circuit comprising a charge pump (14), a loop filter (4) and a summing node (5) is connected between the output of the phase detector (2) and the control input of the oscillator (6).

9. Circuit arrangement as claimed in Claim 8,
**characterized in that**
the output of the modulator (13) is connected to an input on the summing node (5).

10. Circuit arrangement as claimed in one of Claims 1 to 9,
**characterized in that**
a test data generator (37) is designed to generate a periodic signal and has an output which is connected to an input on the modulator (13), and **in that** the trimming path is designed to trim the modulator (13) on the basis of a demodulated signal generated using the periodic signal, the demodulated signal being provided at the output of the demodulator (11).

11. Transceiver with a circuit arrangement as claimed in one of Claims 1 to 10, comprising
- a transmission path (15) for transmitting a modulated signal which contains the circuit arrangement with a phase locked loop (1), operating as a direct modulator and
- a reception path (16) for receiving a modulated signal which contains the demodulator (11).

## Revendications

1. Montage comprenant une boucle (1) à phase asservie et ayant
- une source (3) de référence pour mettre à disposition un signal ayant une fréquence de référence,
- un détecteur (2) de phase ayant une première entrée qui est raccordée à la source (3) de référence, une deuxième entrée et une sortie,
- un oscillateur (6) ayant une entrée de commande qui est couplée à la sortie du détecteur (2) de phase et une sortie qui est couplée à la deuxième entrée du détecteur (2) de phase,
- un modulateur (13) ayant une sortie sur laquelle est mise à disposition un signal de modulation et qui est couplée à l'entrée de commande de l'oscillateur (6),
**caractérisé par**
- un trajet d'ajustement du modulateur (13) comprenant un mélangeur (9) de fréquences ayant une première entrée qui est couplée à la sortie de l'oscillateur (6), une deuxième entrée qui est couplée à la source (3) de référence et une sortie qui est couplée à une entrée de commande du modulateur (13) par un démodulateur (11).

2. Montage suivant la revendication 1,
**caractérisé en ce que,** pour coupler la sortie de l'oscillateur (6) à la deuxième entrée du détecteur (2) de phase, il est prévu un diviseur (7) de fréquence pour subdiviser le signal de sortie de l'oscillateur (6).

3. Montage suivant la revendication 2,
**caractérisé en ce que** le diviseur (7) de fréquence a une entrée de commande constituée pour apporter le signal de modulation sous une forme codée numériquement.

4. Montage suivant l'une des revendications 1 à 3,
**caractérisé en ce qu'**il est prévu, pour coupler la deuxième entrée du mélangeur (9) de fréquence à la source (3) de référence, il est prévu un multiplicateur (10) de fréquence pour multiplier la fréquence de référence.

5. Montage suivant l'une des revendications 1 à 4,
**caractérisé en ce que,** pour coupler le démodulateur (11) à l'entrée de commande du modulateur (13), il est prévu une unité (12) d'exploitation.

6. Montage suivant la revendication 5,
**caractérisé en ce qu'**il est monté un filtre passe bas entre le démodulateur (11) et l'unité (12) d'exploitation

7. Montage suivant 1a revendication 5,
**caractérisé en ce que** le démodulateur (11) est couplé à l'unité (12) d'exploitation par un circuit série comprenant un interrupteur (29) et un filtre (30) passe bande, la bande passante du filtre (30) étant adaptée à la fréquence du signal périodique produit par le générateur (37) de données de test.

8. Montage suivant l'une des revendications 1 à 7,
**caractérisé en ce que** l'oscillateur (6) est réalisé sous la forme d'un oscillateur commandé par la tension et **en ce qu'**un circuit série, composé d'une pompe (14) de charge d'un filtre (4) à boucle et d'un noeud (5) de sommation, est monté entre la sortie du détecteur (2) de phase et l'entrée de commande de l'oscillateur (6).

9. Montage suivant la revendication 8,
**caractérisé en ce que** la sortie du démodulateur (13) est reliée à une entrée du noeud (5) de sommation.

10. Montage suivant l'une des revendications 1 à 9,
**caractérisé en ce qu'**un générateur (37) de données de test est conçu pour produire un signal périodique et a une sortie qui est raccordée à une entrée du démodulateur (13) et **en ce que** le trajet d'ajustement du modulateur (13) est conçu en fonction d'un signal démodulé produit par le signal périodique, le signal démodulé étant mis à disposition à la sortie du démodulateur (11).

11. émetteur récepteur comprenant un montage suivant l'une des revendications 1 à 10, et comprenant
- une branche (15) d'émission, pour émettre un signal modulé, dans laquelle est monté le montage à boucle (1) à phase asservie qui fonctionne en modulateur direct et,
- une branche (16) de réception d'un signal modulé, dans laquelle le démodulateur (11) est monté.
